# EUROPÄISCHE PATENTSCHRIFT

(11) **EP 3 430 085 B1**
(45) Veröffentlichungstag und Bekanntmachung des Hinweises auf die Patenterteilung: **24.06.2020**
(21) Anmeldenummer: 17713175.2
(22) Anmeldetag: 08.03.2017
(51) Int. Cl.: C08L 83/04

(54) **MATERIALIEN FÜR DIE LED-VERKAPSELUNG**
MATERIALS FOR ENCAPSULATING LEDS
MATÉRIAUX POUR ENCAPSULATION DE DEL

(30) Priorität: 15.03.2016 DE 102016104790
(43) Veröffentlichungstag der Anmeldung: 23.01.2019
(73) Patentinhaber: Fraunhofer Gesellschaft zur Förderung der angewandten Forschung e.V., 80686 München (DE); OSRAM Opto Semiconductors GmbH, 93055 Regensburg (DE)
(72) Erfinder: DOMANN, Gerhard, 97204 Höchberg (DE); COLLIN, Daniela, 97440 Werneck (DE); CRONAUER, Carola, 97082 Würzburg (DE)
(74) Vertreter: Strehl Schübel-Hopf & Partner
(86) Internationale Anmeldenummer: PCT/EP2017/055479
(87) Internationale Veröffentlichungsnummer: WO 2017/157743

(56) Entgegenhaltungen:
- US-A1- 2015 252 220
- DATABASE WPI Week 200924 Thomson Scientific, London, GB; AN 2009-E50157 XP002769326, -& JP 2009 024117 A (SONY CORP) 5. Februar 2009 (2009-02-05)

## Beschreibung

Die vorliegende Erfindung betrifft ein Komposit, das sich vorwiegend als Verkapselungsmaterial von LEDs eignet und eine Matrix, in die Matrix eingebettete Partikel sowie ein Dispergierungsmittel aufweist, wobei das Dispergierungsmittel die in der Matrix dispergierten Partikel umhüllt.

Ein häufiges Problem bei LED-Anwendungen ist eine zu geringe Lichtauskopplungseffizienz (Light extraction efficiency; LEE) der Halbleiter-Lichtquelle. Diese liegt unter anderem begründet in dem hohen Brechzahlunterschied zwischen den Halbleitermaterialien des LED-Chips und der die LED umgebende Luft. Aufgrund dieses Unterschieds wird ein Großteil des emittierten Licht durch Totalreflexion intern reflektiert und nicht wie gewünscht ausgesendet. Damit sinkt die Helligkeit und Effizienz der LED. Eine weitere unerwünschte Folge des eingeschlossenen Lichts kann eine vermehrte Wärmeentwicklung sein, die ebenfalls die Auskopplungseffizienz, auch als Konversionseffizienz bezeichnet, reduziert und zu einer verstärkten Degradation des Bauteils führen kann (verringerte Device Reliability). Ebenfalls wünschenswert ist die Möglichkeit, das aus der LED austretende Licht, das häufig blau bzw. kaltfarben ist, in wärmeres, längerwelliges Licht zu konvertieren.

Um die unerwünscht hohe Brechzahlkontrast zwischen Chip und Luft zu reduzieren, wird der LED-Chip häufig mit einem Verkapselungsmaterial verkapselt. Typische Verkapselungsmaterialien sind dabei bisher Epoxy- oder siliconbasierte Systeme. Die Vorteile von epoxybasierten Harzen liegen dabei vor allem in der guten Haftung des Materials an den Gehäusematerialien, der hohen Transparenz, den relativ hohen Brechzahlen und den geringen Kosten. Dadurch sind sie gut geeignet für Niedrig-Energie-LEDs. Silicone dagegen sind zwar teurer und haben häufig eine etwas geringere Brechzahl im Vergleich zu den Epoxysystemen; allerdings weisen sie in der Regel eine höhere thermische Stabilität auf, weshalb sie auch häufiger in Hoch-Energie-LEDs Anwendungen finden.

Hochbrechende Silicone erreichen Brechzahlen von ca. 1,45 bis zu ca. 1,54 oder 1,55. Diese Brechzahlen sind jedoch noch deutlich geringer als die Brechzahlen des emittierenden Materials der LED (häufig z.B. GaN, n=2,47 @ 460nm). Aus diesem Grund ist die LEE allein durch die Verkapselung mit diesen Materialien immer noch nicht zufriedenstellend.

Hochbrechende, transparente und thermisch und lichtstabile stabile Materialien werden als Verkapselungsmaterialien auch für andere technische Bereiche benötigt, beispielsweise bei OLED-Anwendung, in Photovoltaik-Anwendungen, in Projektoren in der Displayindustrie und bei allen optische und opto-elektronischen Systemen, bei denen höhere Temperaturen (z.B. > 150°C Dauerbelastung) bzw. hohe optische Leistungen verwendet werden (beispielsweise > 40 mW/cm² @ 405 nm). Auch in diesen Bereichen ist das Erreichen einer möglichst hohen Brechzahl der Materialien wünschenswert.

Die Steigerung der Brechzahl des Verkapselungsmaterials wird bisher z.B. durch die Zugabe von molekularen anorganischen Komponenten, vor allem von (Übergangs)metallverbindungen bewirkt, da diese häufig eine hohe Brechzahl besitzen. Neben der Strategie, die Brechzahl der Matrix durch den Einbau von z.B. Titan(IV)- oder Zirkonium(IV)-Verbindungen auf molekularer Ebene (siehe z.B. Y. Lai, "Highly transparent thermal stable silicone/titania hybrid with high refractive index for LED encapsulation", J. Coat. Technol. Res. 2015, 12(6), 1185-1192 ,JP 2009-024117 A oder US 2010/025724 A1) zu erhöhen und hybridpolymere Harze herzustellen, kann die Brechzahl des Verkapselungsmaterials auch durch die Zugabe von anorganischen Nanopartikeln (z.B. Oxiden oder Sulfiden) gesteigert werden. Voraussetzung dabei ist, dass die Größe der Nanopartikel deutlich unterhalb der Wellenlänge des entsprechenden Lichts liegt, um so Streuprozesse möglichst weitgehend zu vermeiden. Das Streuverhalten und die Brechzahlsteigerung sind zwei komplementäre mögliche Eigenschaften der Nanopartikel in der Verkapselungsmatrix (Komposit-System).

In einer Reihe von Druckschriften wird die Entwicklung eines hochbrechenden, kettenförmigen Polyorganosiloxans mit Vinylgruppen als vernetzende Einheiten beschrieben, deren Brechzahl durch die Einarbeitung von Nanopartikeln gesteigert werden kann. Allerdings beschreiben Autoren die Kompositherstellung nicht; sie gehen auch nicht auf etwaige Schwierigkeiten ein, die bei der Einarbeitung aufgrund von Kompatibilitätsproblemen auftreten können.

Im Einzelnen werden in US 2006/105480 A1 kettenförmige und endgruppenfunktionalisierte Polyorganosiloxane beschrieben, deren Brechzahl mit mindestens 1,50 angegeben wird. Welche Brechzahlen des Komposits tatsächlich erreicht werden können, ist nicht erkennbar.

In US 2009/140284 A1 wird ein hochbrechender Hardcoat, ebenfalls auf Polysiloxan-Basis, vorgestellt, dessen Brechzahl durch die Zugabe von Nanopartikeln weiter gesteigert werden kann. Die Polysiloxane sind über typische Vernetzungsreaktionen (z.B. Methacrylat- bzw. Epoxypolymerisation) vernetzt.

In US 2010/025724 A1 wird ein hochbrechendes, dreidimensional vernetztes Polysiloxan als Verkapselungsmaterial für LEDs beschrieben. Die Synthesen dieses Materials verlaufen nichthydrolytisch, d.h. ohne zusätzliche Wasserzugabe für die Hydrolysereaktion während des Aufbaus des anorganischen Netzwerks. Dies gelingt durch den Einsatz von Silanolen als notwendiger Komponente. Darüber hinaus ist auch die Stöchiometrie, also das mögliche molare Verhältnis zwischen zusätzlich organisch vernetzbaren siliciumhaltigen Komponenten und aromatischen siliciumhaltigen Komponenten, welche die Brechzahl des Harzes erhöhen sollen, auf ein quasi-stöchiometrisches Verhältnis zwischen Silanol- und Alkoxysilangruppen beschränkt. Der Versuch, die Brechzahl durch weitere Erhöhung des Anteils an aromatischen Bestandteilen weiter zu steigern, muss daher ausgehend von der in US 2010/025724 A1 berichteten Route an seine Grenzen stoßen. Die Autoren in US 2010/025724 A1 berichten im Übrigen ebenfalls über die Möglichkeit, Nanopartikel zur weiteren Brechzahlsteigerung einzusetzen.

Die Herausforderungen, welche alle gleichzeitig und in ihrer Gesamtheit bei der Herstellung von hochbrechenden Kompositen für die Verkapselung von LEDs beachtet werden müssen, sind im Wesentlichen:

### A. Stabilität der nicht-agglomerierten Nanopartikel

Eine hohe Stabilität kann durch gezielte und optimierte Nanopartikelsynthesen und ggf. durch anschließende Oberflächen-Funktionalisierung erreicht werden. Bei der Nanopartikelsynthese werden häufig hydrothermale oder solvothermale Syntheserouten (z.B. wie bei S. Zhou, "Dispersion Behavior of Zirconia Nanocrystals and Their Surface Functionalization with Vinyl Group-Containing Ligands", Langmuir 2007, 23, 9178 beschrieben) sowie kontrollierte Fällungsreaktionen (siehe z.B. T. C. Monson "A simple low-cost synthesis of brookite TiO2 nanoparticles", J. Mater. Res. 2013, 28(3), 348) gewählt und Trocknungs- und Sinterschritte vermieden, um so die Gefahr von irreversiblen Agglomerationen zu vermeiden. Allerdings werden auch in einigen Veröffentlichungen Syntheserouten beschrieben, bei denen trotz Trocknungsschritten anschließend agglomeratfreie Nanopartikeldispersionen hergestellt werden können, siehe z.B. US 2009/140284.

### B. Kompatibilität von Nanopartikel und Matrix

Eine gute Kompatibilität von Nanopartikeln (NP) und Matrix kann dadurch erzielt werden, dass die Oberflächen der NPs mit organischen Gruppen funktionalisiert werden. Dies gelingt insbesondere dann, wenn es sich bei den Nanopartikeln um metalloxidische Partikel handelt. Diese Funktionalisierung hat, wie zuvor bereits erwähnt, zum einen eine Stabilisierung der einzelnen Partikel durch sterische (oder auch elektronische) Abschirmung zur Folge. Darüber hinaus können jedoch funktionelle Gruppen auch eingeführt werden, um die Polarität der anorganischen, oxidischen Partikel an die der organischen bzw. hybriden Matrix anzupassen. Zudem können auf diesem Weg reaktive Gruppen integriert werden, die eine direkte kovalente Anbindung der Partikel an die Matrix bei der Endhärtung ermöglichen, wodurch die Kompatibilität weiter verbessert werden kann. Gängige Beispiele hierfür sind alkoxysilanfunktionalisierte Metalloxid-Partikel wie ZrO₂-Nanopartikel für die Einarbeitung in Silikon-, Arcrylat- oder Epoxyharze (siehe z.B. US 2009/140284 A), epoxy- und/oder methacrylatfunktionalisierte ZrO₂-Nanopartikel für die Einarbeitung in Epoxyharze wie von P.T. Chung in "ZrO2 / epoxy nanocomposite for LED encapsulation", Mater. Chem. Phys. 2012, 136, 868 beschrieben und isopropanolfunktionalisierte TiO₂-Partikel zur Anwendung in einem Silikonharz, siehe z.B. C.-C. Tuan, "Ultra-High Refractive Index LED Encapsulant", IEEE Electronic Components & Technology Conference 2014, 447. Die Oberflächenfunktionalisierung ist dabei nicht begrenzt auf die Verwendung einer einzelnen Komponente. Vielmehr können auch verschiedene Oberflächenmodifikatoren zusammen eingesetzt werden. Bei allen vorgestellten Varianten ist zu beachten, dass eine anschließende Oberflächenfunktionalisierung zur Vergilbungseigenschaft massiv beitragen kann.

Bei der Strategie der Oberflächen-Funktionalisierung der Partikel zur Anpassung der Kompatibilität muss für jedes Matrixmaterial die Polarität zwischen Partikel und Matrix angepasst werden. Eine Einarbeitung scheitert häufig, wenn bei speziellen Matrixmaterialien, die nicht die typischen funktionellen Gruppen wie Methacrylat-, Acrylat-, Styryl-, Epoxy- oder Amino-Funktionen besitzen bzw. nicht durch typische Vernetzungsreaktionen wie radikalischer oder kationischer Polymerisation vernetzt werden, keine passenden funktionellen Gruppen für die Funktionalisierung gefunden werden können.

### C. Schichtdicken der Komposite (ca. 500 µm-1mm) und Probleme mit Rissbildung

Die Herstellung von Verkapselungen für LEDs erfordert häufig die Prozessierbarkeit des Materials in Form dicker Schichten (z.B. in Form von Linsen mit ca. 1mm Dicke). Wenn eine hohe Anzahl an vernetzenden Gruppen vorhanden ist, kann bei der Aushärtung des Verkapselungsmaterials eine zu hohe innere Spannung generiert werden, welche dann durch Rissbildung kompensiert wird. Denn es gibt zwei wesentliche Gründe für eine erhöhte Rissbildungstendenz: Zum einen wird diese bei verstärkter anorganischer Vernetzung (insbesondere durch Tri- anstatt Dialkoxysilane) verursacht, und zum anderen sind hierfür reaktive Gruppen wie die organischen funktionellen Gruppen verantwortlich, die zur Netzwerkbildung befähigt sind, z.B. (Meth-)Acrylate, Epoxide, Styrylgruppen und dergleichen.

Um derart dicke Schichten rissfrei herstellen zu können, muss daher die Rissanfälligkeit des Materials verringert bzw. optimiert werden. Dies lässt sich durch die Anpassung der Anzahl reaktiver Gruppen oder auch den Einbau von flexiblen und langkettigen molekularen Bausteinen erreichen. Beispiele hierfür sind in US 2002/195935 A für ein granuliertes, epoxybasiertes Matrixmaterial genannt, bei dem nicht nur dicke Schichten sondern sogar freistehende Verkapselungskörper vorgestellt werden. US 2006/105480 A beschreibt Verkapselungsmaterialien, die aus kettenförmigen Dimethyl-/Methylphenyl-Polysiloxanen aufgebaut sind und sich mittels UV-Belichtung aushärten lassen. Hierbei erlauben die endgruppenfunktionalisierten Polysiloxanketten die Prozessierung als dicke Schicht aufgrund des relativ geringen Anteils an reaktiven Gruppen im Vergleich zur anorganischen Netzwerkgröße. Im Unterschied zu kettenförmigen Silikonen, die aus Dialkoxysilanen als Precursoren aufgebaut werden, lassen sich Verkapselungsmaterialien auf Basis von Polysiloxanen auch durch die Verwendung von Trialkoxysilanen synthetisieren, deren polymere Struktur weniger auf der Ausbildung von Ketten, sondern viel mehr von dreidimensionalen anorganisch-vernetzten Oligomeren beruht. Durch die Verwendung von Precursoren mit reaktiven organischen funktionellen Gruppen tragen derartige Oligomere, deren anorganisches Netzwerk durch Hydrolyse und Kondensation erhalten wurde, die reaktiven Gruppen auf der Oberfläche, wodurch auch eine starke dreidimensionale organische Vernetzung im Härtungsschritt erreicht werden kann. Von dieser Materialklasse berichten sowohl die Autoren von US 2010/025724 A1 als auch die von WO 2012/097836 A1. Für die Herstellung von Proben mit hohen Schichtdicken von ca. 1 mm Höhe, wie in US 2010/025724 A1 vorgestellt muss hierbei die organische Vernetzung und daher auch die Anzahl an reaktiven Gruppen kontrolliert werden, um eine Rissbildung bei hohen Schichtdicken zu vermeiden.

Ein hoher Anteil an aromatischen Gruppen wie Phenylgruppen, der zur Erzielung einer hohen Brechzahl des Systems hochwillkommen ist, ist in Hinblick auf die Vermeidung von Rissbildung dagegen günstig, da sie keiner Vernetzung zugänglich sind und daher das Matrixmaterial eher weich und flexibel machen.

### D. Stabilität der hochbrechenden Komposite (Temperatur, UV)

Die thermische Stabilität des Verkapselungsmaterials bei gleichzeitiger Bestrahlung mit intensiver Lichtleistung (v.a. auch energiereichem blauem Licht, wie es von den meisten anorganischen LED-Materialien emittiert wird) ist eine weitere Herausforderung. Wie bereits erwähnt, sind Silicone deutlich stabiler als epoxybasierte Harze. Speziell bei der Verwendung von phenylarmen Silikonen wird eine hohe Vergilbungsstabilität erreicht.

Ein Nachteil der Verwendung von phenylarmen Silikonen ist jedoch, dass bei der Substitution der Phenyl- durch Methylgruppen die Brechzahl der Siliconmatrix signifikant verringert wird (die Brechzahl von Methyl-Silikonen liegt bei ca. 1.41, diejenige von Phenyl-Silikonen bei ca. 1.53-1.54). In eine solche thermisch und gegenüber UV-Bestrahlung stabile, dabei aber niedrigbrechenden Matrix müssten dementsprechend deutlich mehr hochbrechende Partikel eingearbeitet werden, um die Brechzahl auf den gewünschten Wert von wenigstens ca. 1,53-1.54 zu steigern. Dies kann jedoch wiederum die Verarbeitbarkeit des Komposits begrenzen, da die Viskosität des Komposits mit steigendem Partikelgehalt sehr schnell ansteigt und eine Prozessierung erschwert, zumal bei manchen Anwendungsfällen und Prozesstechniken nur lösungsmittelfreie Materialien verarbeitet werden sollen.

Um diesen letztgenannten Nachteil zu vermeiden, müsste eine möglichst hochbrechende Matrix verwendet werden, damit für den gewünschten Brechzahlhub weniger Partikel benötigt werden. Dabei wäre es natürlich besonders günstig, wenn man eine Matrix einsetzen könnte, deren Brechzahl sogar noch über der der üblichen Silikone (also über ca. 1,54 oder 1,55) liegt, so dass die Einarbeitung von relativ geringen Mengen an Partikeln ausreichen würde, um die gewünschten Eigenschaften zu erhalten.

### E. Vernetzungsfähigkeit/Aushärteverhalten

Ein hoher Anteil an aromatischen Gruppen wie Phenylgruppen ist mit dem Nachteil verknüpft, dass neben der anorganischen Vernetzung kaum eine organische Vernetzung mehr stattfinden kann. Denn zwei bis drei der vier am Silicium gebundenen Reste müssen für die Ausbildung des anorganischen Netzwerks einer hydrolytischen Kondensation unterworfen werden können (also z.B. in Form von Alkoxygruppen vorliegen), und die Phenylgruppen stehen für eine organische Vernetzung nicht zur Verfügung, da sie anders als z.B. Styrylgruppen keine organisch polymerisierbaren Reste aufweisen. Dies mindert die Möglichkeit, das Material in ausreichendem Maße auszuhärten.

Es ist Aufgabe der Erfindung, eine hochbrechendes, vergilbungsstabiles, transparentes Komposit mit darin dispergierten Nanopartikeln auf Polysiloxanbasis bereitzustellen, das sich in den erforderlichen Dicken auf ein Substrat aufbringen und ohne Rissbildung härten lässt und das aufgrund dieser Eigenschaften zur Verkapselung von LEDs und ähnlichen Aufgaben geeignet ist.

Gelöst wird diese Aufgabe durch ein Kompositmaterial gemäß Anspruch 1 (ungehärtet) sowie ein Komposit gemäss Anspruch 13 (gehärtet), umfassend eine polysiloxanhaltige Matrix, ein Dispergierungsmittel sowie dispergierte Partikel mit Durchmessern im µm- bis nm-Bereich, worin
(a) die polysiloxanhaltige Matrix zumindest im ungehärteten Zustand einen höheren Brechungsindex und eine höhere Oberflächenspannung als das Dispergierungsmittel besitzt, unter Verwendung von mindestens zwei unterschiedlichen Silanen, wobei mindestens eines der Silane mehrere aromatische Gruppen trägt, aufgebaut ist sowie organische Gruppen aufweist, welch letztere über ein Verbrückungsmittel miteinander verbrückbar sind, wobei sowohl die aromatischen Gruppen als auch die organischen, verbrückbaren Gruppen jeweils über Kohlenstoff an ein Siliciumatom gebunden sind, wobei die Matrix zusätzlich ein Verbrückungsmittel zum Verbrücken der organisch verbrückbaren Gruppen und bei Bedarf einen für die Verbrückungsreaktion erforderlichen Katalysator aufweist, derart, dass die organisch verbrückbaren Gruppen im gehärteten Zustand zumindest teilweise über eine Additionsreaktion mit dem Verbrückungsmittel reagiert haben,
(b) das Dispergierungsmittel (i) entweder thermisch und/oder unter Einwirkung von Licht organisch vernetzbare Gruppen oder Si-H-Gruppen sowie (ii) aromatische Gruppen aufweist,
wobei die Partikel mit Durchmessern im µm- bis nm-Bereich zuerst mit dem Dispergierungsmittel gemischt wurden und die entstandene Mischung mit der polysiloxanhaltigen Matrix vereinigt wurde,
mit der Maßgabe, dass sich unter den aromatischen Gruppen des Komposits keine Styrylgruppen befinden, oder dass der Anteil an Styrylgruppen bei unter 5 Mol%, vorzugsweise unter 1 Mol%, bezogen auf die Gesamt-Molmenge an aromatischen Gruppen im Komposit, liegt.

Die Erfindung basiert auf der Erkenntnis, dass es bisher keine transparenten, thermisch und optisch stabilen Komposite aus sehr hochbrechenden Matrices und geeigneten Partikel mit Durchmessern im µm- bis nm-Bereich gibt, da Matrices, die im Übrigen die erforderlichen Eigenschaften besitzen, mit den jeweils gewünschten oder erforderlichen Partikel mit Durchmessern im µm- bis nm-Bereich inkompatibel sind derart, dass die gebildeten Komposite opak sind, wie die Erfinder durch Vergleichsversuche feststellen mussten. Mit den gleichen, hochbrechenden Matrix-Materialien und Nanopartikeln lassen sich dagegen klare, hochbrechende Komposite erhalten, sofern zusätzlich ein geeignetes Dispergierungsmittel mit einem etwas geringeren Brechungsindex vorgesehen wird. Mit diesem zusätzlichen Dispergierungsmittel kann daher eine Matrix mit einem sehr hohen Brechungsindex und mit einer relativ hohen Oberflächenspannung (einer höheren Polarität) gewählt werden, ohne dass hierbei styrylgruppenhaltige Silane eingesetzt werden müssten, was erfindungsgemäß wegen der damit einhergehenden Vergilbungserscheinungen zu vermeiden ist. Aufgrund des in der Matrix vorhandenen Verbrückungsmittels entstehen beim Aushärten relativ langkettige organische Verbrückungen, die eine Rissbildung verhindern. Kleinere Verunreinigungen an Styrylen, deren Anteil so gering ist, dass eine Vergilbung nicht eintritt, sind dabei unschädlich. Die Polysiloxanmatrix wird mittels kontrollierter Hydrolyse- und Kondensationsreaktionen aus zwei oder mehr als zwei hydrolytisch kondensierbaren Silanen erzeugt, insbesondere solchen, die zwei und/oder drei Alkoxygruppen tragen, wie aus dem Stand der Technik bekannt. Die Zahl der hydrolytisch kondensierbaren Gruppen kontrolliert die Art des sich bildenden anorganischen Netzwerks: während Silane mit zwei solchen Gruppen vorwiegend Ketten und/oder Ringe bilden, führt der Einsatz von Silanen mit drei solchen Gruppen zu einem verzweigten Netzwerk. Silane mit nur einer hydrolytisch kondensierbaren Gruppe können als Kettenterminator dienen und sind daher erfindungsgemäß gegebenenfalls ebenfalls in geringeren Mengen einsetzbar. Die Matrix besitzt erfindungsgemäß zumindest vor der Aushärtung einen höheren Brechungsindex und eine höhere Oberflächenspannung als das Dispergierungsmittel. Hierfür trägt mindestens eines der dafür eingesetzten Silane mehrere aromatische Gruppen, die in der Regel über Kohlenstoff an das Siliciumatom angebunden sind. Solche Gruppen tragen zu einer hohen Brechzahl des Harzes bei, wobei dem Fachmann klar ist, dass die Anzahl dieser Gruppen für die Größe der Brechzahlsteigerung verantwortlich ist. Es ist daher bevorzugt, wenn ein möglichst hoher Anteil der Ausgangssilane, z.B. bis zu ca. 70 Gew.-%, eine oder vorzugsweise zwei solche Gruppen trägt. Als aromatische Gruppen eignen sich insbesondere Arylgruppen, wie unsubstituierte oder substituierte Phenylgruppen oder kondensierte aromatische Gruppen wie Naphthyl- oder Anthranylgruppen. Auch Reste mit zwei oder mehr voneinander isolierten Phenylresten wie Bisphenol-A-Derivate sind einsetzbar. Als Substituenten der aromatischen Ringe bieten sich vorzugsweise Alkylgruppen oder andere, (vorzugsweise nur) auf Kohlenstoff, Wasserstoff und optional Sauerstoff basierende Gruppen wie Polyoxyalkylen-Reste an. Aufgrund der bekannten Vergilbungseigenschaften soll erfindungsgemäß die hohe Brechzahl jedoch im Wesentlichen oder ganz unter Verzicht auf den Einsatz von Styrylgruppen bewirkt werden, so dass eine Substitution von Phenylgruppen als aromatischen Gruppen mit Vinyl ganz oder im Wesentlichen ausgeschlossen ist.

Der Brechungsindex kann dem Grunde nach frei gewählt werden; aufgrund des vorgesehenen Einsatzgebietes sollte er jedoch so hoch wie möglich sein. Günstig und auch erreichbar sind Werte, die zumindest höher als die bisher kommerziell verfügbaren Werte von bis zu 1,54 oder 1,55 liegen. Vorzugsweise besitzt die Matrix zumindest vor der Aushärtung also einen Brechungsindex von 1,56 oder darüber, stärker bevorzugt von mindestens etwa 1,57 oder 1,58. Beispiele für aromatische Silane der Matrix sind Mono- oder Diarylsilane, die zwei hydrolysierbare (hydrolytisch kondensierbare) Gruppen oder OH-Gruppen tragen. Eine kleine Menge an Monoarylsilanen kann ebenfalls zugesetzt werden. Die Verwendung von Diarylsilanen ist bevorzugt. Beispiele sind Diphenylsilane mit zwei hydrolysierbaren Gruppen, beispielsweise Dialkoxydiphenylsilane wie Dimethoxydiphenylsilan.

Ein zweites Silan trägt über ein Verbrückungsmittel organisch verbrückbare Gruppen, die beim Aushärten des Harzes mit diesem Verbrückungsmittel reagieren und dabei relativ langkettige organische Verbrückungen ausbilden. Typische organisch verbrückbare Gruppen besitzen C=C-Doppelbindungen, wie zum Beispiel (Meth)acryl-, Allyl, Norbornen- oder Vinylgruppen, oder auch Epoxy-, Mercapto- oder Aminogruppen, und sind in der Lage, mit den reaktiven Gruppen des Verbrückungsmittels eine Additionsreaktion einzugehen.

Beispiele für Silane, die über ein Verbrückungsmittel organisch verbrückbare Gruppen aufweisen, sind Vinyl- und Allylsilane, die z.B. über Si-H-Gruppen oder SH-Gruppen (mittels einer Thiol-en-Addition) organisch verbrückt werden können. Geeignet sind insbesondere Vinyl- und Allylsilane mit drei hydrolytisch kondensierbaren Gruppen wie Vinyltrialkoxysilane oder Allyltrialkoxysilane, wobei Silane, die zwei Vinyl- oder Allylgruppen tragen, ebenfalls eingesetzt werden können. Die Vinyl- bzw. Allylgruppe ist dabei vorzugsweise direkt an das Siliciumatom angebunden. In einer weniger bevorzugten Alternative handelt es sich bei diesen Silanen um solche, die beispielsweise (Meth-)Acrylgruppen aufweisen, welche ebenfalls mit Si-H-Gruppen oder SH-Gruppen organisch verbrückt werden können. Umgekehrt können dann, wenn das Verbrückungsmittel beispielsweise (Meth-)Acrylgruppen besitzt, diese Silane Mercaptosilane (Thiosilane) sein. Die Liste an Möglichkeiten kann der Fachmann anhand der gegebenen Bedingungen ohne weiteres fortsetzen.

In der vorliegenden Erfindung soll der Ausdruck "(Meth-)Acryl" "Methacryl und/oder Acryl" bedeuten.

Als Verbrückungsmittel dient eine Verbindung, die mindestens zwei reaktive, an die genannten organisch verbrückbaren Gruppen addierbare Reste aufweist, oder eine Kombination aus zwei oder mehr dieser Verbindungen. Bei den reaktiven Resten kann es sich z.B. um Mercaptogruppen handeln, die durch eine Thiol-en-Addition an (Meth)acrylat- oder Norbonengruppen anbinden können, um reaktive Wasserstoffgruppen, die an einer Allyl- oder Vinylgruppe anbinden können, oder um Hydroxygruppen, die an einer Epoxygruppe anbinden können. Enthält das Silan als organisch verbrückbare Gruppen seinerseits Mercapto- oder Aminogruppen, können als reaktive Reste des Verbrückungsmittels auch vorzugsweise aktivierte, nichtaromatische C=C-Doppelbindungen enthaltende Reste eingesetzt werden wie (Meth-)Acryl-Reste. Günstig ist es weiterhin, wenn auch das Verbrückungsmittel auch aromatische Gruppen trägt, um ein "Verdünnen" dieser Gruppen in der Matrix durch den Zusatz des Verbrückungsmittels zu vermeiden. Wenn das Verbrückungsmittel mehr als zwei, beispielsweise drei reaktive Reste aufweist, kann es vernetzend wirken.

Durch den erfindungsgemäß möglichen Verzicht auf die bekanntlich zur Vergilbung beitragenden Styrylgruppen ergibt sich eine deutlich erhöhte Stabilität des hochbrechenden Polykondensats gegenüber herkömmlichen höherbrechenden Phenylsilikonen.

Als Verbrückungsmittel kann, muss aber nicht, ebenfalls eine Silanverbindung eingesetzt werden. Wenn diese reaktive Wasserstoffgruppen aufweisen soll, kann es sich dabei um Si-H-Gruppen handeln. Alternativ kann es sich beispielsweise um ein Thiosilan handeln, dessen Thiogruppe an einen Silylrest gebunden ist, der über Kohlenstoff an das Silicium gebunden ist. Besonders geeignet ist eine Verbindung, die zwei Siliciumatome mit aktiven Gruppen, z.B. Si-H-Gruppen, trägt. Diese beiden Siliciumatome können über eine Diphenylen-Etherbrücke miteinander verbunden sein. Ein konkretes Beispiel ist Bis[(p-dimethylsilyl)phenyl]ether).

Bei Ersatz von Styrylgruppen durch aromatische Derivate ohne organisch vernetzbaren Gruppen wie die Vinylgruppe ist die Vernetzungsfähigkeit des Material erst einmal herabgesetzt, wie oben dargelegt, was das Aushärteverhalten negativ beeinflussen kann. Dies wird dadurch kompensiert, dass ein Teil der organischen, über Kohlenstoff an Silicium gebundenen Reste über eine Additionsreaktion mit einem Verbrückungsmittel verbrückt wird, das mindestens zwei reaktive Gruppen aufweist. Durch die reaktiven Gruppen des Verbrückungsmittels erhöht sich die Gesamtzahl an reaktiven Gruppen. Günstig ist z.B. die Zugabe eines Verbrückungsmittels mit zwei reaktiven Gruppen, beispielsweise Si-H-Gruppen, in einer solchen Menge zu dem Silan, das verbrückbare Gruppen, z.B. Vinylgruppen, aufweist, dass das Verhältnis der reaktiven Gruppen des Verbrückungsmittels zur Anzahl an verbrückbaren Gruppen am Silan stöchiometrisch ist. Denn hierdurch steigt die Anzahl an verbrückbaren Gruppen auf das Doppelte. Dabei ist es besonders günstig, wenn die Atomkette zwischen mindestens zwei der reaktiven Reste des Verbrückungsmittels möglichst viele Glieder aufweist, weil die Verbrückung dann zu einem relativ weitmaschigen Netzwerk führt, wobei allerdings wiederum zu beachten ist, dass lange aliphatische Ketten die Brechzahl senken. Dies gilt jedoch nicht für ausgedehntere aromatische Ketten, deren aromatische Komponenten nicht unbedingt konjugiert vorliegen müssen. Die Kette (gerechnet ohne die reaktiven Reste) zwischen den beiden reaktiven Resten sollte aufgrund der obigen Überlegungen vorzugsweise mindestens 6, stärker bevorzugt mindestens 8 Kettenglieder aufweisen, wobei für eventuell vorhandene Ringe wie Phenylringe die kürzeste Strecke gerechnet wird, die zwischen den beiden Bindungsstellen der Ringe liegt. Bei p-Phenyl-Strukturen sind das beispielsweise 4 (Kohlenstoff-)Atome.

Aufgrund der in der Regel wässrigen Synthese des Polykondensats ist grundsätzlich eine freie Wahl bezüglich der Stöchiometrie der verschiedenen Silan-Präkursoren möglich. Das Verhältnis von aromatische Gruppen enthaltenden Silanen zu organisch verbrückbaren Gruppen ist dabei dem Grunde nach nicht kritisch, solange eine ausreichende Menge an aromatischen Gruppen vorhanden ist, damit der gewünschte, hohe Brechungsindex erreicht wird. Günstig ist natürlich ein möglichst hoher Anteil an aromatischen Gruppen. In Hinblick darauf, dass die Brechzahl möglichst hoch sein sollte, gleichzeitig aber gewährleistet sein muss, dass ein ausreichender Anteil an organisch verbrückbaren Gruppen vorhanden ist, mit dessen Hilfe das Harz ausgehärtet werden kann, ist es vorteilhaft, das aromatenhaltige Silan in einem molaren Anteil, bezogen auf die Summe von aromatischen Gruppen und organisch verbrückbaren Gruppen, von bis ca. 80% einzusetzen, wobei dieser Anteil aber unter gegebenen Umständen sogar bis auf ca. 95%, vorzugsweise bis auf ca. 90% steigen kann (beispielsweise liegt der Anteil bei einer Verwendung von 30 Mol-% Vinyltrialkoxysilan und 70 Mol-% Dialkoxydiphenylsilan bei ca. 82 Mol-%). Auf der anderen Seite erhält man durch die Verwendung einer ausreichenden Menge an organisch vernetzbaren Gruppen eine mechanisch stabile Matrix, weshalb der Anteil dieser Gruppen nicht zu gering sein sollte. Günstig ist es, wenn deren Anteil, bezogen auf die Summe der aromatischen und der organisch vernetzbaren Gruppen, bei nicht unter 5 Mol-%, vorzugsweise nicht unter 8 Mol-% liegt (beispielsweise liegt der Anteil bei einer Verwendung von 15 Mol-% Vinyltrialkoxysilan und 85 Mol-% Dialkoxydiphenylsilan bei ca. 8 Mol-%). Stärker bevorzugt liegt dieser Anteil aber etwas höher, beispielsweise bei ca. 20, ggf. sogar bis zu ca. 30 Mol-%.

Das Verbrückungsmittel für die organisch vernetzbaren Gruppen wird vorteilhaft in stöchiometrischem Anteil gewählt, d.h. in einer derartigen Menge, dass jede verbrückbare Gruppe stöchiometrisch mit einem reaktiven Rest des Vernetzungsmittels abreagieren kann. Sofern das Polykondensat aus den mindestens zwei verschiedenen Silan-Präkursoren unter Einsatz einer nicht ausreichend hohen Menge an aromatische Gruppen aufweisenden Silanen hergestellt wurde, um die Brechzahl der Matrix ausreichend hoch (und höher als die des Dispersionsmittels) einstellen zu können, sollte das Vernetzungsmittel seinerseits einen möglichst hohen Anteil an aromatische Gruppen enthalten, um der Matrix den gewünscht hohen Brechungsindex zu verleihen.

Grundsätzlich ist es möglich, über zusätzliche Präkursoren weitere funktionelle Gruppen in das Polykondensat zu integrieren bzw. die anorganische Netzwerkbildung zu beeinflussen. Ziel bei der Beeinflussung der anorganischen Netzwerkbildung und der Auswahl zusätzlicher funktioneller Gruppen ist neben der hohen Brechzahl des Harzes und der thermischen Stabilität auch zusätzlich die Prozessierbarkeit des Verkapselungsmaterials mit Schichtdicken von bis zu 1 mm oder sogar darüber. Als Beispiel für solche Präkursoren seien Silane mit vier hydrolytisch kondensierbaren Gruppen genannt, die den Anteil an anorganischer Vernetzung erhöhen und damit das Material mechanisch stabiler machen und keiner Schrumpfung unterliegen. Es können auch Silane mit organisch polymerisierbaren, z.B. polyaddierbaren Resten eingesetzt werden, die nicht mit dem Verbrückungsmittel reagieren können, aber in einer späteren Polyreaktion durch Wärme oder Licht vernetzt werden können, wie beispielsweise (Meth-) Acrylatgruppen enthaltende Silane, weil sich hierdurch unter Umständen eine weitere Brechzahlsteigerung ergeben kann, wobei diese Maßnahme mit Vorsicht anzuwenden ist, weil sie mit einer erhöhten Schrumpfungsgefahr einhergeht. Des Weiteren können Silane eingesetzt werden, die eine (oder mehrere) längerkettige Alkylgruppe enthalten, was die Brüchigkeit des späteren Komposits verringert und die Flexibilität des Netzwerks erhöht.

Die Harzmatrix wird vorzugsweise hergestellt, indem die beiden unterschiedlichen Silane, die über ein Verbrückungsmittel organisch vernetzbare Gruppen bzw. aromatische Gruppen tragen, gemeinsam einer hydrolytischen Kondensationsreaktion unterworfen werden. Hierfür werden die Silane vermischt, was in der Regel ohne den Zusatz von Lösungsmittel möglich ist, da die Ausgangskomponenten in der Regel flüssig sind. Sodann wird die Mischung einer Hydrolyse und Kondensation unterworfen, was beispielsweise mit einer unterstöchiometrischen bis stöchiometrischen Menge an Wasser, bezogen auf die vorhandenen hydrolytisch kondensierbaren Reste, und gegebenenfalls einem Katalysator, z.B. Säure wie Salzsäure, bewirkt werden kann. Die bei der Kondensation freiwerdenden Verbindungen wie z.B. Ethanol oder Methanol werden anschließend zusammen mit dem überschüssigen Wasser und vorzugsweise dem Katalysator entfernt, was durch Extraktion mit einem Extraktionsmittel und/oder durch Abziehen (Destillieren) flüchtiger Komponenten bewirkt werden kann. Das dabei entstehende anorganische Kondensat ist ein lagerfähiges Harz. Soll es mit den übrigen Komponenten zum erfindungsgemäßen Komposit verarbeitet werden, werden das Vernetzungsmittel und, bei Bedarf, ein entsprechender Katalysator zugegeben.

Das Dispergierungsmittel wird benötigt, um die Partikel in die hochbrechende Matrix einarbeiten zu können. Auch das Dispergierungsmittel sollte erfindungsgemäß möglichst hochbrechend sein, ohne zu einer Vergilbung der Schicht beizutragen. Aus diesem Grunde ist es vorgesehen, dass es ebenso wie die Matrix aromatische Gruppen trägt, die aus derselben Gruppe von Aromaten, beispielsweise Arylen, ausgewählt sein können, wie oben für die Matrix angegeben. Vorzugsweise sind arylgruppenhaltige Silane die Quelle hierfür. Das Dispergierungsmittel soll zusätzlich organisch vernetzbar sein oder es soll eine organische Brückenbildung ermöglichen.

Die Art der organischen Vernetzbarkeit kann in Hinblick auf die einzusetzenden Partikel gewählt werden, wobei jedoch auch entweder eine Vernetzbarkeit der für das Dispergierungsmittel gewählten vernetzbaren Gruppen untereinander und/oder eine Vernetzbarkeit mit einer Komponente der Matrix ins Auge gefasst werden kann.

Werden die vernetzbaren Gruppen in Hinblick auf die einzusetzenden Partikel gewählt, kann es günstig sein, vernetzbare Gruppen einzusetzen, die thermisch und/oder unter Einwirkung von Licht organisch polymerisieren. Werden nämlich beispielsweise Partikel verwendet, deren Oberfläche ebenfalls mit organisch polymerisierbaren Gruppen besetzt ist, können diese Partikel über die genannten Gruppen mit der entsprechenden Komponente des Dispergierungsmittels copolymerisieren und damit kovalent in das Komposit eingearbeitet werden. Eine Vernetzbarkeit der für das Dispergierungsmittel gewählten organisch vernetzbaren Gruppen und/oder eine Vernetzbarkeit mit einer Komponente der Matrix ist beispielsweise möglich, wenn Gruppen eingesetzt werden, die thermisch und/oder mit Hilfe von Licht einer Polymerisation (engl.: "addition polymerization") unterworfen werden können. Beispiele hierfür sind Gruppen, die vorzugsweise aktivierte C=C-Doppelbindungen enthalten wie Acryl- oder Methacrylgruppen oder Norbornenylgruppen. Eine Vernetzbarkeit mit einer Komponente der Matrix ist beispielsweise dann möglich, wenn das Dispergierungsmittel Si-H-Gruppen aufweist. In diesen Fällen ist eine Vernetzung mit der Matrix und ggf. auch mit den Nanopartikeln möglich, wenn die Matrix und ggf. auch die Partikel auf ihrer Oberfläche C=C-doppelbindungshaltige Gruppen aufweisen. Die vernetzbaren Gruppen werden vorzugsweise über Silane bereitgestellt, die in einer ersten Ausgestaltung der Erfindung einer hydrolytischen Kondensationsreaktion unterworfen werden. Für die Anbindung dieser Gruppen an die Siliciumatome gilt Vergleichbares wie oben für das Matrixharz ausgeführt.

In einem Ausführungsbeispiel wird für ein vinylfunktionalisiertes Harz, das für die Matrix vorgesehen ist, als Dispergierungsmittel ein (meth)acrylatbasiertes Polykondensat gewählt, also eine Polykondensat mit thermisch und/oder unter Einwirkung von Licht organisch polymerisierbaren Gruppen. Diese Gruppen können über Silane eingebracht werden, die diese Gruppen an über Kohlenstoff an das Silicium gebundenen Resten enthalten.

Die aromatischen Gruppen des Dispergierungsmittels können ebenfalls über Silane bereitgestellt werden, die in dieser Variante mit den organisch vernetzbare Gruppen aufweisenden Silanen einer hydrolytischen Co-Kondensation unterworfen werden können. Diese Silane können beispielsweise zwei oder drei hydrolytisch kondensierbare Gruppen sowie eine oder zwei Arylgruppen aufweisen, welch letztere ebenfalls über Kohlenstoff an das Silicium gebunden sind.

In einer Alternative wird das Dispergierungsmittel so gewählt, dass es eine organische Brückenbildung ermöglicht. In diesem Falle wird kein anorganisches Kondensat gebildet. Dieses Dispergierungsmittel wird, im Gegensatz zum polykondensierten Dispergierungsmittel wie oben beschrieben, als molekulares Dispergierungsmittel bezeichnet. Es trägt wie das Verbrückungsmittel des Matrixharzes zwei reaktive Gruppen und kann aus derselben Gruppe von Verbindungen ausgewählt sein wie das Verbrückungsmittel. Gegebenenfalls kann es mit dem Verbrückungsmittel identisch sein.

In einem Ausführungsbeispiel für ein solches Dispergierungsmittel für ein ebenfalls vinylfunktionalisiertes Matrix-Harz kann eine mindestens zwei Si-H-Gruppen enthaltende Silanverbindung gewählt werden, die zunächst mit den Nanopartikel und anschließend mit dem Harz in Kontakt gebracht wird und zur Vernetzung und Aushärtung des Komposits führt. Diese Silanverbindung kann ggf. selbst aromatische Gruppen, beispielsweise Arylgruppen, aufweisen, oder sie wird mit anderen aromatenhaltigen Silanen kombiniert.

Das Dispergierungsmittel hat dabei eine angepasste Polarität, um zwischen den ggf. funktionalisierten Nanopartikeln und der hochbrechenden Matrix zu vermitteln.

Dem Grunde nach ist die Menge, in der es eingesetzt werden soll, nicht beschränkt; sie sollte jedoch ausreichend sein, um die Partikel mit Durchmessern im µm- bis nm-Bereich umhüllen zu können. Der Ausdruck "Umhüllung" soll dabei besagen, dass die Polarität dadurch soweit optimiert wird, dass eine Kompatibilität und Mischbarkeit gegeben ist. Das bedeutet aber nicht, dass eine vollständige Umhüllung im Sinne einer flächendeckenden Bedeckung der Oberfläche der Nanopartikel und einer sterischen Abschirmung zwingend erforderlich ist, auch wenn sie häufig erreicht werden wird. Der Anteil an Dispergierungsmittel, bezogen auf die Summe von Matrix und Dispergierungsmittel, kann daher zwischen 1 und 99 Gew.-% schwanken; in der Regel wird man etwa 10 - 50 Gew.-%, bezogen auf die genannte Summe von Matrix und Dispergierungsmittel, einsetzen.

Überraschenderweise zeigte sich, dass die Dispersionsfähigkeit der Partikel durch die Zugabe des Dispergierungsmittel gesteigert werden kann, auch wenn die verschiedenen Polykondensate der Matrix bzw. des Dispergierungsmittels eine nur gering voneinander abweichende Polarität haben, bezogen auf die Oberflächenspannung.

Die Partikel der Erfindung haben im dispergierten Zustand Durchmesser im µm- bis nm-Bereich. Wenn sie der Brechzahlsteigerung dienen sollen, liegt dieser Durchmesser unterhalb der Wellenlänge des Lichtes, für dessen Durchtritt der erfindungsgemäße Komposit vorgesehen ist und damit zwischen durchschnittlich ca. 400 nm bis ca. 800 nm. Diese Partikel werden auch als Nanopartikel bezeichnet. Wenn die Partikel für die Konversion von Licht vorgesehen sind, wie weiter unten näher erläutert, kann der Durchmesser auch über 800 nm liegen und z.B. gegebenenfalls auch ca. 50 µm erreichen.

Als z.B. brechzahlsteigernde Nanopartikeln können kommerziell erhältliche, an der Oberfläche vorzugsweise mit verschiedensten Gruppen funktionalisierte oder auch nach typischen Synthesevorschriften (z.B. nach S. Zhou, a.a.O.) hergestellte und optional ebenfalls mit verschiedenen Oberflächenreaktionen funktionalisierte Nanopartikel eingesetzt werden. Die Nanopartikel bestehen vorzugsweise aus Metalloxiden oder -nitriden, beispielsweise solchen des Zirkoniums oder Titans. Sie liegen dabei vorzugsweise in Dispersion vor. Die Funktionalisierung kann, muss aber nicht, in einer oder mehreren organisch polymerisierbaren Gruppen liegen, die über eine Silanisierung aufgebracht werden können. Bevorzugt sind organisch vernetzbare bzw. polymerisierbare Gruppen vorhanden, die mit den entsprechenden organisch vernetzbaren Gruppen des Dispergierungsmittels copolymerisieren können.

Anstelle oder zusätzlich zu brechzahlsteigernden Partikel können Partikel eingesetzt werden, mit denen sich die Farbe einer LED gezielt verändern lässt. In diesen Fällen wird das Komposit nicht oder nicht nur zur Verkapselung der LED verwendet; vielmehr dient die das Komposit enthaltende bzw. daraus bestehende Schicht (nur oder zusätzlich) als sogenannte Konversionsschicht. Konversionsschichten enthalten Partikel oder nanoskalige Stoffe, die das von der LED emittierte, kurzwellige, hochenergetische und damit als "kalt" empfundene Licht absorbieren und die dabei absorbierte Energie in Form von Licht längerer Wellenlängen (z.B. gelb) wieder emittieren.

Das aus der LED austretende Licht (im Falle von z.B. InGaN oder GaN als halbleitendem Material meist blau oder sogar im UV-Bereich emittierend) wird bei dieser Technik durch die Konversionsschicht geschickt, die entweder direkt auf dem LED-Chip aufliegt oder einen gewissen Abstand dazu besitzt (letztere wird als "remote phosphor" bezeichnet). In beiden Fällen kann die Schicht gleichzeitig als Verkapselungsschicht dienen. Da ein Teil des von der LED emittierten Lichts ohne Absorption, aber meist gestreut, durch die Konversionsschicht hindurchtritt, führen die aus der Konversionsschicht austretenden Lichtstrahlen in der Summe dann zu einem weißen Lichteindruck. Als Konvertersubstanzen werden häufig Halbleitermaterialien eingesetzt. Wenn es sich um partikelförmige Stoffe (Phosphore) handelt, besitzen diese häufig Durchmesser im µm-Maßstab, z.B. 1-50 µm, die als Pulver eingesetzt werden. Ein Beispiel (das nicht als beschränkend anzusehen sind) ist mit Cer dotiertes Yttrium-Aluminium-Granath Y₃Al₅O₁₂:Ce, ein Material aus der Gruppe mit der allgemeinen Form A₃B₅X₁₂:M, in der es weitere Phosphore gibt. Alternativ können wie erwähnt nanoskalige Konversionsmaterialien (Nanopartikel) eingesetzt werden, die auch als Quantenpunkte bezeichnet werden. Ein typischer Vertreter ist CdSe, welches jedoch in jüngster Zeit aufgrund der Giftigkeit des Kadmiums Konkurrenz von Cd-freien Materialien, z.B. InP oder InP/ZnS sowie sonstigen Sulfiden wie PbS und ZnS bekommt. Diese Konvertermaterialien haben damit ganz allgemein das Ziel, die Leistungsfähigkeit, Effizienz und den Farbwert der LED zu verbessern bzw. zu verändern. Dabei ist eine wesentliche Herausforderung die ausreichende Stabilisierung und Verteilung der Konvertermaterialien in einer entsprechenden Matrix. So muss vor allem vermieden werden, dass die Phosphore am Boden der aufgetragenen Schicht agglomerieren und sich dort anreichern, bevor die Schicht ausgehärtet ist, um Verschiebungen in den Farbpunkten zu vermeiden und die Gleichmäßigkeit der Farbwerte zu ermöglichen.

Das erfindungsgemäße Komposit wird hergestellt, indem das Dispergierungsmittel und die Nanopartikel miteinander vermischt werden, wobei beide Komponenten bei Bedarf in einem geeigneten Lösungsmittel gelöst eingesetzt werden. Das Lösungsmittel wird anschließend entfernt, beispielsweise durch Destillation und ggf. nachfolgendem Aufbringen von Wärme und Unterdruck. Anschließend werden das Harz der Matrix und das mit den Nanopartikeln vermischte Dispergierungsmittel vermischt. Sofern in das Matrixharz noch kein Katalysator für die Verbrückungsreaktion eingearbeitet war, dies aber erforderlich ist, wird dieser Katalysator zu der Mischung gegeben. Gleichfalls wird ein Initiator oder Katalysator für die Polymerisationsreaktion der polymerisierbaren Gruppen des Dispergierungsmittels zugesetzt. Die entstandene Mischung wird sodann ausgehärtet, was vorzugsweise durch Wärme erfolgt.

Erfindungsgemäß wird also die Verwendung eines Dispergierungsmittels als ergänzende Komponente für ein transluzentes, klares, vergilbungsstabiles und hochbrechendes Komposit vorgeschlagen. Mit der Erfindung lassen sich Komposite erhalten, die nach dem Aushärten Brechzahlen von über 1,6, vorzugsweise von über 1,65 aufweisen. So ist es möglich, höherbrechende und auch in Abwesenheit von Styrylverbindungen stabilere Verkapselungssysteme und/oder Konversionsschichten insbesondere für LEDs bereitzustellen, die die LEE steigern.

Ausführungsbeispiele:

### 1. Partikelsysteme

Die in den Beispielen verwendeten Partikel besaßen einen Partikeldurchmesser (DLS, Volumengewichtet, inklusive Funktionalisierungshülle) von etwa 5 bis 8,3 nm. Sie besaßen einen Kern aus ZrO₂ mit einer acrylat- und/oder methacrylat-modifizierten Oberfläche. Ihr Brechungsindex (inklusive Funktionalisierungshülle) lag in allen Fällen bei etwa 1,8. Sie wurden in Form einer 50%igen Suspension in PGMEA (1-Methoxy-2-propyplacetat) eingesetzt.

### 2. Harzsynthese (Matrixharz)

In einem 500ml-Dreihalskolben mit Rührfisch werden 0,15 mol (22,9 g) Vinyltrimethoxysilan und 0,30 mol (75,9 g) Dimethoxydiphenylsilan vorgelegt und gerührt. Anschließend werden 0,495 mol (8,91 g) 0,5 N Salzsäure-Lösung zu getropft und für zehn Minuten gerührt. Anschließend reagiert die Mischung für 24 h bei 80°C im Ölbad. Nach der abgeschlossenen Reaktion wird die Reaktionsmischung in 270 ml Ethylacetat aufgenommen und bis zur pH-Neutralität mit jeweils 115 ml Wasser gewaschen. Das so erhaltene Harz wird anschließend über einen hydrophoben Filter gereinigt und die restlichen leicht flüchtigen Bestandteile destillativ entfernt. Die Brechzahl des so erhaltenen Harzes beträgt 1,5795 (598 nm, 20 °C, Abbe-Refraktometer). Für eine Aushärtung des Harzes werden 0,589 g (Bis[(p-dimethylsilyl)phenyl]ether), 1 Gew.-% einer 1,8.10⁻³ gew.-%igen Lösung von Platinum(0)-1,3-divinyl-1,1,3,3-tetramethyldisiloxan in Xylol bezogen auf das Harz mit 2,0 g Harz gemischt. Die Oberflächenspannung desHarzes beträgt 37,8 mN/m. Die Brechzahl der ausgehärteten Schicht beträgt 1,5970 (635 nm, Prismenkoppler).

Mit der Molmasse der Si-H Verbindung von 286,52 g/mol ergibt sich bei 0,589 g eine Stoffmenge von 2,06 mmol. Das molare Verhältnis von Vinyl- zu Diphenylkomponente liegt bei 1:2, daraus ergibt sich eine Massenkonzentration von 16,6 Gew.-% für die hydrolysierte und kondensierte Vinylkomponente im Harz. Das bedeutet, dass 2.0 g Harz 0,332 g der hydrolysierten und kondensierten Vinylkomponente enthalten. Mit einer Molmasse von 79 g/mol (Methoxygruppen sind wegen der Hydrolyse abzuziehen, die O-Atome werden halb gezählt, da sie zur anorganischen Vernetzung beitragen) ergibt sich eine Stoffmenge von 4,2 mmol Vinylgruppen im Harz. Da die Si-H haltige Verbindung bifunktionell ist, ist das Verhältnis von Si-H Gruppen und Vinylgruppen stöchiometrisch.

### 3. Synthese eines polykondensierten Dispergierungsmittel mit Methacrylatgruppen

In einem 500ml-Dreihalskolben mit Rührfisch werden 0,20 mol (49,9 g) 3-Methacryloxypropyltrimethoxysilan und 0,40 mol (101 g) Dimethoxydiphenylsilan vorgelegt und gerührt. Anschließend werden 0,66 mol (11.9 g) 0,5 N Salzsäure-Lösung zugetropft und für zehn Minuten gerührt. Anschließend reagiert die Mischung für 24 h bei 80°C im Ölbad. Nach der abgeschlossenen Reaktion wird die Reaktionsmischung in 360 ml Ethylacetat aufgenommen und bis zur pH-Neutralität mit jeweils 150 ml Wasser gewaschen. Das so erhaltene Harz wird anschließend über einen hydrophoben Filter aufgereinigt und die restlichen leicht flüchtigen Bestandteile destillativ entfernt. Die Brechzahl des so erhaltenen Harzes beträgt 1,5681 (598 nm, 20°C) und die Oberflächenspannung beträgt 35,6 mN/m. Trotz des relativ geringen Unterschieds in der Oberflächenspannung bewirkt das Dispergierungsmittel, dass die verwendeten ZrO₂-Nanopartikel optimal dispergiert werden können und eine agglomerationsfrei, transparente Schicht hergestellt werden kann. Die Brechzahl der ausgehärteten Schicht beträgt 1,583 (635 nm, Prismenkoppler).

### 4. Herstellung von Kompositen mit Hilfe eines polykondensierten Dispergierungsmittels

In einem ersten Schritt werden in einem 250 ml Rundkolben 2,08 g Dispergierungsmittel (siehe Beispiel 3) in 50 ml 1-Methoxy-2-propylacetat gelöst. Zu dieser Lösung kommen 8,91 g einer 50 gew.-%igen Lösung von oberflächenfunktionalisierten ZrO₂-Nanopartikel in 1-Methoxy-2-propylacetat. Die Mischung wird für 30 Minuten im Ultraschallbad behandelt. Anschließend wird das Lösungsmittel destillativ entfernt. Letzte Reste der leicht flüchtigen Bestandteile werden im Vakuumofen bei 60°C entfernt und so die dispergierte Nanopartikel-Mischung erhalten. In einem zweiten Schritt werden für die Matrix 4,78 g eines Harzes aus Vinyltrimethoxysilan und Dimethoxydiphenylsilan im Molverhältnis 1 : 2 wie oben im Beispiel 2 beschrieben mit 1,41 g (Bis[(p-dimethylsilyl)phenyl]ether) gemischt und für zwei Stunden gerührt.

Anschließend werden die beiden Mischungen so vereint, dass das Verhältnis von Dispergierungsmittel zu Harz 2,1 : 1 beträgt, und die Kompositmischung für vier Stunden bei Raumtemperatur gerührt. Anschließend erfolgt die Zugabe von 0,1 Gew.-% Dicumylperoxid bezogen auf das Dispergierungsmittel und 1 Gew.-% einer 1,8.10⁻³ gew.-%igen Lösung von Platinum(0)-1,3-divinyl-1,1,3,3-tetramethyldisiloxan in Xylol bezogen auf das Harz.

Die anschließende Aushärtung dünner Schichten dieses Komposits kann erfolgen durch eine dreistufige Ofenbehandlung bei z.B. zunächst 100°C für zwei Stunden, 150°C für eine Stunde und abschließend 180°C für ebenfalls eine Stunde. Die Brechzahl des ZrO₂-haltigen Komposits mit Hilfe eines polykondensierten Dispergierungsmittels beträgt 1.650 (635 nm -Prismenkopplermessung an ausgehärteten Proben).

### 5. Herstellung von Kompositen mit Hilfe eines molekularen Dispergierungsmittels mit Si-H Gruppen

In einem ersten Schritt werden in einem 50 ml Rundkolben 0,573 g (Bis[(p-dimethylsilyl)phenyl]ether) vorgelegt. Anschließend werden 2,87 g einer 50 gew.-%igen Lösung von oberflächenfunktionalisierten ZrO₂-Nanopartikel in 1-Methoxy-2-propylacetat zugetropft. Die Mischung wird für 15 Minuten bei Raumtemperatur gerührt, gefolgt von der Zugabe von 0,0218 g einer 1,81,8·10⁻³ gew.-%igen Lösung von Platinum(0)-1,3-divinyl-1,1,3,3-tetramethyldisiloxan in Xylol. Die Reaktionsmischung wird zunächst für 24 h bei 60°C und anschließend für 4 h bei 80°C im Ölbad gerührt und so die Dispergierbarkeit im Harz erreicht. Anschließend werden zur Reaktionsmischung 1,438 g des Harzes (siehe Beispiel 2) zugegeben und das so erhaltene, transparente Komposit für eine weitere Stunde bei Raumtemperatur gerührt.

Die anschließende Aushärtung dünner Schichten dieses Komposits erfolgt bei 100°C für 7 h im Ofen. Die Brechzahl der so erhaltenen ZrO₂-haltigen Kompositschichten mit Hilfe eines molekularen Dispergierungsmittel mit SiH-Gruppen beträgt 1.635 (635 nm - Prismenkoppler-Messung der ausgehärteten Schicht). Die Brechzahl von Schichten aus dem reinen Harz (siehe Beispiel 2) beträgt bei dieser Messmethode 1.597 (635 nm, Prismenkoppler).

### 6. Vergleichsbeispiel ohne Dispergiermittel

Zunächst werden 2.18 g einer 50 gew.-%igen Lösung von oberflächenfunktionalisierten ZrO₂-Nanopartikeln in 1-Methoxy-2-propylacetat in einem 50 ml Rundkolben vorgelegt. Nacheinander werden 0,439 g (Bis[(p-dimethylsilyl)phenyl]ether), 0,015 g einer 1,81,8.10⁻³ gew.-%igen Lösung von Platinum(0)-1,3-divinyl-1,1,3,3-tetramethyldisiloxan in Xylol sowie 1,099 g des Harzes aus Vinyltrimethoxysilan und Dimethoxydiphenylsilan im Molverhältnis 1 : 2 wie oben im Beispiel 2 beschrieben zugegeben. Die Mischung wird insgesamt für 24 h bei Raumtemperatur gerührt. Die anschließende Aushärtung dünner Schichten dieses Komposits erfolgt bei 100°C für 7 h im Ofen. Die sich dabei bildende Schicht ist nicht transparent, sondern weiß und trüb. Rasterelektronische Untersuchungen des Kompositquerschnittes zeigen eine verstärkte Agglomeration der ZrO₂ Nanopartikel. Die Größe der dabei entstehenden Agglomerate beträgt dabei zwischen ca. 400 nm und mehreren 10 µm und liegt somit im Bereich streuender Partikel.

**Übersicht über die Eigenschaften (Schichtqualität, Brechzahl) der erhaltenen Komposite (Partikelgehalt: 12 Vol.-%)**

| | | | |
|---|---|---|---|
| Komposite aus ZrO₂ und Basis-Harz (aus Bsp. 1) | Ohne Dispergiermittel | Mit molekularem Dispergiermittel mit SiH-Gruppen | Mit polykondensiertem Dispergiermittel (Methacrylatgruppen) |
| Schichtqualität | × | ✔ | ✔ |
| | trüb | Klar, transparent | Klar, transparent |
| Brechzahl der Kompositschichten (Prismenkoppler, 635 nm) | Nicht bestimmbar | 1,635 | 1.650 |

### 7. Vergleichsbeispiel zur Synthese eines polykondensierten Dispergierungsmittel mit Styrylgruppen

In einem 500ml-Dreihalskolben mit Rührfisch werden 0,25 mol (57,02 g) Styryltrimethoxysilan und 0,50 mol (126 g) Dimethoxydiphenylsilan vorgelegt und gerührt. Anschließend werden 0,825 mol (14,9 g) 0,5 N Salzsäure-Lösung zugetropft und für zehn Minuten gerührt. Anschließend reagiert die Mischung für 24 h bei 80°C im Ölbad. Nach der abgeschlossenen Reaktion wird die Reaktionsmischung in 450 ml Ethylacetat aufgenommen und bis zur pH-Neutralität mit jeweils 200 ml Wasser gewaschen. Das so erhaltene Harz wird anschließend über einen hydrophoben Filter aufgereinigt und die restlichen leicht flüchtigen Bestandteile destillativ entfernt. Die Brechzahl des so erhaltenen Harzes beträgt 1,5983 (598 nm, 20°C, Abbe-Refraktometer) bzw. der ausgehärteten Schicht 1.6013 (635 nm, Prismenkoppler).

### Vergleich der thermischen Eigenschaften von styryl- bzw. methacrylhaltigem polykondensiertem Dispergiermittel

Die unterschiedliche thermische Stabilität der beiden Dispergiermittel zeigt sich bereits, wenn die reinen Dispergiermittel mit Hilfe von 1 Gew.-% des Starters Dicumylperoxid als 1 mm dicke Schicht bei 150°C für 2 h und abschließend bei180°C für 1 h im Ofen aushärtet werden an den unterschiedlichen Transmissionswerten (siehe Tabelle). Die verstärke Absorption im styrylhaltigen Material durch vergilbende Anteile aus dem Edukt Styryltrimethoxysilan ist deutlich erkennbar. Dieser Effekt wird durch eine anschließende thermische Alterung (72 h, 150°C) noch deutlicher. Aus diesem Grund sind styrylhaltige Dispergierungsmittel nicht geeignet für vergilbungsarme, hochbrechende LED-Verkapselungsmaterialien.

| **Material** | | **Reduktion Transmission bei 400 nm** |
|---|---|---|
| **Polykondensiertes Dispergiermittel (methacrylathaltig)** | Ausgehärtet 150°C / 2 h + 180°C / 0,5 h) | -9% |
| | + thermische Alterung (150 °C / 72 h) | |
| **Polykondensiertes Dispergiermittel (styrylhaltig)** | Ausgehärtet (150°C / 2 h + 180°C / 0,5 h) | - 62% |
| | + thermische Alterung (150°C / 72 h) | |

### 8. Vergleichsbeispiel zur Herstellung eines Komposits mit reinem Dispergiermittel als Matrix

Zunächst werden 3,38 g des Dispergiermittels (nach Beispiel 3) vorgelegt und mit 84,7 g 1-Methoxy-2-propylacetat verdünnt. Die Mischung wird für 15 min im Ultraschallbad homogenisiert. Anschließend werden 11,9 g einer 50 gew.-%igen Lösung von oberflächenfunktionalisierten ZrO₂-Nanopartikel in 1-Methoxy-2-propylacetat zugetropft und die Mischung für weitere 30 min mit Ultraschall behandelt. Aus der Reaktionsmischung wird das Lösungsmittel 1-Methoxy-2-2propylacetat destillativ bis zu einem Restlösemittelgehalt von ca. 4 Gew.-% entfernt und ein thermischer Radikalstarter Dicumylperoxid mit einem Gehalt von 0,3 Gewichtsprozent bezogen auf das Dispergiermittel zugewogen. Die Brechzahl der so hergestellten Kompositmischung betrug 1.6034 (598 nm, 20°C, Abbe-Refraktometer).

Die anschließende Aushärtung dünner Schichten dieses Komposits erfolgt zunächst bei 150°C für 2 h und abschließend 180°C für 1 h im Ofen. Die notwendige hohe Aushärtetemperatur der reinen Matrix führte dabei zur Vergilbung der Partikel bzw. genauer der organischen Gruppen auf der Oberfläche der Partikel und somit zur deutlichen Gelbfärbung des so erhaltenen ausgehärteten Komposits, weshalb die Verwendung des Dispergiermittels als Matrix für die Kompositherstellung hier nicht geeignet ist.

## Patentansprüche

1. Kompositmaterial, umfassend eine polysiloxanhaltige Matrix, ein Dispergierungsmittel sowie dispergierte Partikel mit Durchmessern im µm- bis nm-Bereich, worin
(a) die polysiloxanhaltige Matrix im ungehärteten Zustand einen höheren Brechungsindex und eine höhere Oberflächenspannung als das Dispergierungsmittel besitzt, unter Verwendung von mindestens zwei unterschiedlichen Silanen, wobei mindestens eines der Silane mehrere aromatische Gruppen trägt, aufgebaut ist sowie organische Gruppen aufweist, welch letztere über ein Verbrückungsmittel miteinander verbrückbar sind, wobei sowohl die aromatischen Gruppen als auch die organischen, verbrückbaren Gruppen jeweils über Kohlenstoff an ein Siliciumatom gebunden sind, wobei die Matrix zusätzlich ein Verbrückungsmittel mit mindestens zwei reaktiven Resten zum Verbrücken der organisch verbrückbaren Gruppen und bei Bedarf einen für die Verbrückungsreaktion erforderlichen Katalysator aufweist, derart, dass die organisch verbrückbaren Gruppen im gehärteten Zustand zumindest teilweise über eine Additionsreaktion mit dem Verbrückungsmittel reagiert haben, und
(b) das Dispergierungsmittel (i-1) thermisch und/oder unter Einwirkung von Licht organisch vernetzbare Gruppen oder (i-2) Si-H-Gruppen sowie (ii) aromatische Gruppen aufweist,
wobei die Partikel mit Durchmessern im µm- bis nm-Bereich zuerst mit dem Dispergierungsmittel gemischt wurden und die entstandene Mischung mit der polysiloxanhaltigen Matrix vereinigt wurde,
mit der Maßgabe, dass sich unter den aromatischen Gruppen des Komposits keine Styrylgruppen befinden, oder dass der Anteil an Styrylgruppen bei unter 5 Mol%, bezogen auf die Gesamtstoffmenge an aromatischen Gruppen im Komposit, liegt.

2. Kompositmaterial nach Anspruch 1, worin die polysiloxanhaltige Matrix mindestens ein erstes Silan, das unter Silanen mit ein bis drei hydrolytisch kondensierbaren Gruppen ausgewählt ist und mindestens eine aromatische Gruppe trägt, die über Kohlenstoff an das Siliciumatom des Silans gebunden sind, und mindestens ein zweites Silan aufweist, das unter Silanen mit ein bis drei hydrolytisch kondensierbaren Gruppen ausgewählt ist und mindestens eine organische Gruppe aufweist, welche über ein Verbrückungsmittel mit einer ebensolchen organischen Gruppe eines zweiten solchen Silanmoleküls verbrückbar ist.

3. Kompositmaterial nach Anspruch 2, worin das erste Silan ausgewählt ist unter Dialkoxydiphenylsilanen, Trialkoxyphenylsilanen, Derivaten dieser Silane, in denen die Phenylgruppen mit aus Kohlenstoff, Wasserstoff und gegebenenfalls Sauerstoff aufgebauten Gruppen, substituiert sind und Mischungen der vorgenannten Silane, und/oder worin das zweite Silan ausgewählt ist unter Trialkoxyvinylsilanen, Trialkoxyallylsilanen, Trialkoxysilanen, die eine über Kohlenstoff an das Siliciumatom des Silans gebundene Methacrylgruppe, Acrylgruppe oder Norbornenylgruppe tragen, Trialkoxysilanen, die eine über Kohlenstoff an das Siliciumatom des Silans gebundene Epoxy, Thio- oder Aminogruppe tragen, und Mischungen der vorgenannten Silane.

4. Kompositmaterial nach Anspruch 3, worin das zweite Silan ausgewählt ist unter Trialkoxyvinylsilanen, Trialkoxyallylsilanen, Trialkoxysilanen, die eine über Kohlenstoff an das Siliciumatom des Silans gebundene Methacrylgruppe, Acrylgruppe oder Norbornenylgruppe tragen, sowie Mischungen dieser Silane, und worin das Verbrückungsmittel mindestens zwei reaktive Reste trägt, die ausgewählt sind unter Si-H-Gruppen und SH-Gruppen.

5. Kompositmaterial nach Anspruch 3, worin das zweite Silan ausgewählt ist unter Trialkoxysilanen, die eine über Kohlenstoff an das Siliciumatom des Silans gebundene Thio- oder Aminogruppe tragen, und Mischungen der vorgenannten Silane, und worin das Verbrückungsmittel mindestens zwei reaktive Reste trägt, die ausgewählt sind unter Acryl- und Methacrylgruppen.

6. Kompositmaterial nach Anspruch 3, worin das zweite Silan ausgewählt ist unter Trialkoxysilanen, die eine über Kohlenstoff an das Siliciumatom des Silans gebundene Epoxygruppe tragen, und worin das Verbrückungsmittel als reaktive Reste mindestens zwei Hydroxygruppen trägt.

7. Kompositmaterial nach einem der voranstehenden Ansprüche, worin das Verbrückungsmittel ein Silan ist.

8. Kompositmaterial nach einem der voranstehenden Ansprüche, worin das Verbrückungsmittel mindestens eine aromatische Gruppe aufweist.

9. Kompositmaterial nach einem der voranstehenden Ansprüche, worin das Verbrückungsmittel eine Kettenlänge, gerechnet von einem ersten reaktiven Rest zu einem zweiten reaktivem Rest ohne Berücksichtigung der reaktiven Reste selbst, von mindestens 6 Atomen aufweist.

10. Kompositmaterial nach einem der voranstehenden Ansprüche, worin das molare Verhältnis von silangebundenen organisch verbrückbaren Gruppen und am Verbrückungsmittel befindlichen reaktiven Resten im Bereich von 1,1 bis 0,9 zu 0,9 bis 1,1 liegt.

11. Kompositmaterial nach einem der voranstehenden Ansprüche, worin die Gruppen des Dispergierungsmittels, die thermisch und/oder mit Hilfe von Licht vernetzbar sind, eine Polymerisationsreaktion eingehen können und ausgewählt sind unter Gruppen, die vorzugsweise aktivierte C=C-Doppelbindungen enthalten.

12. Kompositmaterial nach einem der voranstehenden Ansprüche, worin das Dispergierungsmittel ein polysiloxanhaltiges Material ist, das aus mindestens zwei hydrolytisch kondensierbaren Silanen aufgebaut ist, wobei das erste Silan entweder thermisch und/oder unter Einwirkung von Licht organisch vernetzbare Gruppen oder Si-H-Gruppen und das zweite Silan aromatische Gruppen trägt.

13. Komposit, erhalten durch Aushärten des Kompositmaterials nach einem der voranstehenden Ansprüche.

14. Verfahren zum Herstellen eines Kompositmaterials nach einem der Ansprüche 1 bis 12, wobei eine Dispersion der Partikel mit Durchmessern im µm- bis nm-Bereich mit dem Dispergierungsmittel vermischt und sodann mit der polysiloxanhaltigen Matrix vereinigt wird.

15. Verfahren zum Herstellen eines Komposits nach Anspruch 13, wobei eine Dispersion der Partikel mit Durchmessern im µm- bis nm-Bereich mit dem Dispergierungsmittel vermischt und sodann mit der polysiloxanhaltigen Matrix vereinigt wird, worauf das entstandene Kompositmaterial durch Licht und/oder Wärme zum Komposit ausgehärtet wird.

## Claims

1. A composite material comprising a polysiloxane-containing matrix, a dispersant and dispersed particles having diameters in the µm to nm range, wherein
(a) the polysiloxane-containing matrix in the uncured state has a higher refractive index and a higher surface tension than the dispersant, is formed by using at least two different silanes, wherein at least one of the silanes carries several aromatic groups, and has organic groups, which are bridgeable with one another via a bridging agent, wherein both the aromatic groups and the organic bridgeable groups are each bonded to a silicon atom via carbon, wherein the matrix additionally comprises a bridging agent with at least two reactive radicals for bridging the organically bridgeable groups and, if required, a catalyst required for the bridging reaction, in such a way that the organically bridgeable groups have reacted at least partially with the bridging agent via an addition reaction in the cured state, and
(b) the dispersant (i-1) has groups which are organically crosslinkable thermally and/or under the action of light or (i-2) Si-H groups and (ii) aromatic groups,
wherein the particles with diameters in the µm to nm range were first mixed with the dispersant and the resulting mixture was combined with the polysiloxane-containing matrix,
with the proviso that there are no styryl groups among the aromatic groups of the composite, or that the proportion of styryl groups is less than 5 mol%, based on the total amount of aromatic groups in the composite.

2. The composite material according to claim 1, wherein the polysiloxane-containing matrix comprises at least one first silane selected from silanes having from one to three hydrolytically condensable groups and bearing at least one aromatic group bonded to the silicon atom of the silane via carbon, and at least one second silane selected from silanes having from one to three hydrolytically condensable groups and bearing at least one organic group which is bridgeable via a bridging agent with an identical organic group of a second such silane molecule.

3. The composite material according to claim 2, wherein the first silane is selected from dialkoxydiphenylsilanes, trialkoxyphenylsilanes, derivatives of these silanes in which the phenyl groups are substituted with groups built up from carbon, hydrogen and optionally oxygen, and mixtures of the aforementioned silanes, and/or wherein the second silane is selected from trialkoxyvinylsilanes, Trialkoxyallylsilanes, trialkoxysilanes which carry a methacrylic, acrylic or norbornenyl group bonded to the silicon atom of the silane via carbon, trialkoxysilanes which carry an epoxy, thio or amino group bonded to the silicon atom of the silane via carbon, and mixtures of the abovementioned silanes.

4. The composite material according to claim 3, wherein the second silane is selected from trialkoxyvinylsilanes, trialkoxyallylsilanes, trialkoxysilanes carrying a methacrylic group, acrylic group or norbornenyl group bonded to the silicon atom of the silane via carbon, and mixtures of these silanes, and wherein the bridging agent carries at least two reactive radicals selected from Si-H groups and SH groups.

5. The composite material according to claim 3, wherein the second silane is selected from trialkoxysilanes carrying a thio or amino group bonded to the silicon atom of the silane via carbon, and mixtures of the aforementioned silanes, and wherein the bridging agent carries at least two reactive radicals selected from acrylic and methacrylic groups.

6. The composite material according to claim 3, wherein the second silane is selected from trialkoxysilanes which carry an epoxy group bonded to the silicon atom of the silane via carbon, and wherein the bridging agent carries at least two hydroxy groups as reactive residues.

7. The composite material according to any of the preceding claims, wherein the bridging agent is a silane.

8. The composite material according to any of the preceding claims, wherein the bridging agent comprises at least one aromatic group.

9. The composite material according to any of the preceding claims, wherein the bridging agent has a chain length, calculated from a first reactive radical to a second reactive radical without taking into account the reactive radicals themselves, of at least 6 atoms.

10. The omposite material according to any of the preceding claims, wherein the molar ratio of silane-bound organically bridgeable groups and reactive moieties attached to the bridging agent is in the range of 1.1 to 0.9 to 0.9 to 1.1.

11. The composite material according to any of the preceding claims, wherein the groups of the dispersant which are crosslinkable thermally and/or by means of light are capable of undergoing a polymerization reaction and are selected from groups which preferably contain activated C=C double bonds.

12. The composite material according to any of the preceding claims, wherein the dispersant is a polysiloxane-containing material which is composed of at least two hydrolytically condensable silanes, the first silane carrying groups which are organically crosslinkable either thermally and/or under the action of light or Si-H groups and the second silane carrying aromatic groups.

13. A composite, obtained by curing the composite material according to one of the preceding claims.

14. A process for the preparation of a composite material according to any one of claims 1 to 12, wherein a dispersion of the particles having diameters in the µm to nm range is mixed with the dispersant and then combined with the polysiloxane-containing matrix.

15. The process for the preparation of a composite according to claim 13, wherein a dispersion of the particles with diameters in the µm to nm range is mixed with the dispersant and then combined with the polysiloxane-containing matrix, whereupon the resulting composite material is cured by light and/or heat to form the composite.

## Revendications

1. Matériau composite, comprenant une matrice contenant du polysiloxane, un agent dispersant ainsi que des particules dispersées présentant des diamètres de l'ordre du µm au nm, dans lequel:
(a) la matrice contenant du polysiloxane possède à l'état non durci un indice de réfraction plus élevé et une tension superficielle plus élevée que l'agent dispersant, est construite en utilisant au moins deux silanes différents, dans lequel au moins un des silanes porte plusieurs groupes aromatiques, et présente des groupes organiques, ces derniers pouvant être pontés l'un l'autre au moyen d'un agent de pontage, dans lequel aussi bien les groupes aromatiques que les groupes organiques pouvant être pontés sont liés par du carbone à un atome de silicium, dans lequel la matrice présente en outre un agent de pontage comportant au moins deux radicaux réactifs pour le pontage des groupes pouvant être pontés organiquement et au besoin un catalyseur nécessaire pour la réaction de pontage, de telle manière que les groupes pouvant être pontés organiquement aient réagi, à l'état durci, au moins partiellement par une réaction d'addition avec l'agent de pontage, et
(b) l'agent dispersant présente (i-1) des groupes pouvant être réticulés thermiquement et/ou organiquement par exposition à la lumière ou (i-2) des groupes Si-H ainsi que (ii) des groupes aromatiques,
dans lequel les particules présentant des diamètres de l'ordre du micromètre au nanomètre ont d'abord été mélangées avec l'agent dispersant et le mélange obtenu a été nettoyé avec la matrice contenant du polysiloxane,
à la condition que, parmi les groupes aromatiques du composite, il ne se trouve pas de groupes styryle ou que la proportion de groupes styryle se situe en dessous de 5 % molaires, rapportée à la quantité totale de groupes aromatiques dans le composite.

2. Matériau composite selon la revendication 1, dans lequel la matrice contenant du polysiloxane présente au moins un premier silane, qui est choisi parmi les silanes comportant un à trois groupes condensables par hydrolyse et qui porte au moins un groupe aromatique, qui sont liés par du carbone à l'atome de silicium du silane, et au moins un second silane qui est choisi parmi les silanes comportant un à trois groupe(s) condensable(s) par hydrolyse et au moins un groupe organique, qui peut être ponté au moyen d'un agent de pontage à un groupe organique équivalent d'une seconde molécule de silane similaire.

3. Matériau composite selon la revendication 2, dans lequel le premier silane est choisi parmi les dialcoxydiphénylsilanes, les trialcoxyphénylsilanes, des dérivés de ces silanes, dans lesquels les groupes phényle sont substitués avec des groupes constitués de carbone, d'hydrogène et éventuellement d'oxygène, et des mélanges des silanes précités, et/ou dans lequel le second silane est choisi parmi les trialcoxyvinylsilanes, les trialcoxyallylsilanes, les trialcoxysilanes, qui portent un groupe méthacryle, acryle ou norbornényle, les trialcoxysilanes, qui portent un groupe époxy, thio ou amino, lié par du carbone à l'atome de silicium du silane, ainsi que des mélanges des silanes précités.

4. Matériau composite selon la revendication 3, dans lequel le second silane est choisi parmi les trialcoxyvinylsilanes, les trialcoxyallylsilanes, les trialcoxysilanes, qui portent un groupe méthacryle, un groupe acryle ou un groupe norbornényle lié par du carbone à l'atome de silicium du silane ainsi que des mélanges de ces silanes, et dans lequel l'agent de pontage porte au moins deux radicaux réactifs, qui sont choisis parmi des groupes Si-H et des groupes SH.

5. Matériau composite selon la revendication 3, dans lequel le second silane est choisi parmi les trialcoxysilanes, qui portent un groupe thio ou amino lié par du carbone à l'atome de silicium du silane, et des mélanges de ces silanes, et dans lequel l'agent de pontage porte au moins deux radicaux réactifs, qui sont choisis parmi les groupes acryle et méthacryle.

6. Matériau composite selon la revendication 3, dans lequel le second silane est choisi parmi les trialcoxysilanes, qui portent un groupe époxy lié par du carbone à l'atome de silicium du silane, et dans lequel l'agent de pontage porte comme radicaux réactifs au moins deux groupes hydroxy.

7. Matériau composite selon l'une quelconque des revendications précédentes, dans lequel l'agent de pontage est un silane.

8. Matériau composite selon lune quelconque des revendications précédentes, dans lequel l'agent de pontage présente au moins un groupe aromatique.

9. Matériau composite selon l'une quelconque des revendications précédentes, dans lequel l'agent de pontage présente une longueur de chaîne, calculée d'un premier radical réactif à un second radical réactif, sans tenir compte des radicaux réactifs eux-mêmes, d'au moins 6 atomes.

10. Matériau composite selon l'une quelconque des revendications précédentes, dans lequel le rapport molaire des groupes pouvant être pontés organiquement liés par silane et des radicaux réactifs se trouvant sur l'agent de pontage se situe dans la plage de 1,1 à 0,9 à 0,9 à 1,1.

11. Matériau composite selon l'une quelconque des revendications précédentes, dans lequel les groupes de l'agent dispersant, qui peuvent être réticulés thermiquement et/ou à l'aide de la lumière, peuvent subir une réaction de polymérisation et sont choisis parmi des groupes, qui contiennent de préférence des liaisons doubles C=C activées.

12. Matériau composite selon l'une quelconque des revendications précédentes, dans lequel l'agent dispersant est un matériau contenant du polysiloxane, qui est composé d'au moins deux silanes pouvant être condensés par hydrolyse, dans lequel le premier silane porte soit des groupes pouvant être réticulés thermiquement ou organiquement à l'aide de la lumière soit des groupes Si-H et le second silane porte des groupes aromatiques.

13. Composite, obtenu par durcissement à cœur du matériau composite selon l'une quelconque des revendications précédentes.

14. Procédé de fabrication d'un matériau composite selon l'une quelconque des revendications 1 à 12, dans lequel on mélange une dispersion des particules présentant des diamètres de l'ordre du µm au nm avec l'agent dispersant et on la nettoie ensuite avec la matrice contenant du polysiloxane.

15. Procédé de fabrication d'un composite selon la revendication 13, dans lequel on mélange une dispersion des particules présentant des diamètres de l'ordre du µm au nm avec l'agent dispersant et on la nettoie ensuite avec la matrice contenant du polysiloxane, après quoi on durcit le matériau composite obtenu en un composite au moyen de la lumière et/ou de la chaleur.
